# EUROPEAN PATENT APPLICATION

(11) **EP 3 260 894 A1**
(43) Date of publication of application: **27.12.2017**
(21) Application number: 15881532.4
(22) Date of filing: 12.02.2015
(51) Int. Cl.: G02B 5/10, F24J 2/12, E04D 13/18

(54) **CONCENTRATED SOLAR ENERGY SYSTEM**

(71) Applicant: Bolymedia Holdings Co. Ltd., Santa Clara, California 95051 (US)
(72) Inventor: HU, Xiaoping, Shenzhen, Guangdong 518055 (CN)
(74) Representative: Manitz Finsterwald Patentanwälte PartmbB
(86) International application number: PCT/CN2015/072943
(87) International publication number: WO 2016/127370

(57) **Abstract**

A concentrated solar energy system, comprising a convergence system, a double-sided photovoltaic panel (pi) and a support component, wherein the convergence system comprises at least one tooth surface (s5) and a reflection surface (s6), each tooth surface containing at least one Fresnel unit, and the reflection surface being arranged below the tooth surface along a sunlight incident direction; and the double-sided photovoltaic panel is arranged above the reflection surface along the sunlight incident direction, and is basically located at a focusing location of the convergence system. A double-sided photovoltaic panel is used and is arranged above a reflection surface along a sunlight incident direction, and thus on one hand, a back surface of the photovoltaic panel can absorb sunlight converged via a convergence system, and on the other hand, a front surface thereof can also absorb directly radiated sunlight, such that in the same spatial size, the capacity of a photovoltaic panel for absorbing and utilizing solar energy is effectively improved.

## Description

### Technical Field

The present invention relates to the technical field of clean energy, in particular to a concentrated solar energy system for using solar energy.

### Background Art

With the increasing emphasis on environmental protection, solar energy systems have been used more and more widely. Common solar energy systems at present are installed on roofs or on road surfaces, such as solar water heating systems based on photothermal conversion and solar power generation systems based on photo-electric conversion.

In these common solar energy systems, their energy conversion devices, such as solar vacuum tubes or photovoltaic panels, typically face sunlight directly and the areas of their own working surfaces are the maximum areas they can receive sunlight, and thus energy collected by the traditional solar energy systems is very limited, and the larger the area of a photovoltaic panel is, the higher the cost is.

In order to improve the ability to collect solar energy, there has been a concentrated solar system. For example, Chinese patent application, with publication No. CN101640502A, discloses "Method for Assembling Condenser Photoelectrical Solar Cell Array" where sunlight is converged on a photovoltaic panel through a lens so that the photovoltaic panel with a smaller area can obtain sunlight converged from the lens with a larger area.

However, the use of existing condenser lenses is limited by a lot of installation conditions, resulting in low cost performance. In order to make better use of limited space and reduce costs, it is still desirable to improve the capability of photovoltaic panels for collecting and using solar energy.

### Summary of the Invention

According to the present invention, a concentrated solar energy system is provided, comprising a convergence system, a double-sided photovoltaic panel and a support component, wherein the convergence system comprises at least one tooth surface and a reflection surface, each tooth surface containing at least one Fresnel unit, and the reflection surface being arranged below the tooth surface along a sunlight incident direction; the double-sided photovoltaic panel is arranged above the reflection surface along the sunlight incident direction, and is basically located at a focusing location of the convergence system, and the double-sided photovoltaic panel is used for absorbing incident sunlight from two direction, i.e., from a front surface and a back surface; and the support component is used for supporting the convergence system and the double-sided photovoltatic panel and maintaining the relative position relationship therebetween.

The concentrated solar energy system according to the present invention uses the double-sided photovoltaic panel which is arranged above the reflection surface along the sunlight incident direction, and thus on one hand, the back surface of the photovoltaic panel can absorb sunlight converged via the convergence system, and on the other hand, the front surface thereof can also absorb directly radiated sunlight (or sunlight converged via other convergence system), such that in the same spatial size, the capacity of the photovoltaic panel for absorbing and utilizing solar energy is effectively improved. Furthermore, as the Fresnel refraction surface and the reflection surface are both used, the entire system can be arranged in a small space and therefore suitable for many typical mounting ways, such as installation by means of a roof, installation by means of a wire pole, installation by means of an umbrella surface, etc.

Since the cost of the convergence system is far lower than that of the photovoltaic panel, a large-area low-cost convergence system is used in the present invention to increase the convergence area, so that the area of the high-cost photovoltaic panel can be reduced, thereby greatly reducing the cost of the solar energy system. It is preferable when a reflection lens which also has a concentration capability is used to provide a reflection surface to achieve obvious effect.

Specific examples according to the present invention are described in detail below with reference to the accompanying drawings.

### Brief Description of the Drawings

Fig. 1 is a schematic diagram of two coaxial surfaces for generating a Fresnel refraction surface according to the present invention;
Fig. 2 is a schematic diagram of several arrangements of a composite Fresnel refraction surface according to the present invention;
Fig. 3 is a schematic diagram of a convergence system having two tooth surfaces according to the present invention;
Fig. 4 is a schematic diagram of a Fresnel reflection lens according to the present invention;
Fig. 5 is a schematic diagram of several original lenses used for making reflection lenses according to the present invention;
Fig. 6 is a schematic diagram of the basic structure of a concentrated solar energy system according to the present invention;
Fig. 7 is a schematic diagram of the concentrated solar energy system of Embodiment 1;
Fig. 8 is a schematic diagram of the concentrated solar energy system of Embodiment 2;
Fig. 9 is a schematic diagram of the concentrated solar energy system of Embodiment 3; and
Fig. 10 is a schematic diagram of the concentrated solar energy system of Embodiment 4.

### Detailed Description of the Preferred Embodiments

The convergence system used in the concentrated solar energy system according to the present invention employs a Fresnel lens, and for the sake of understanding, the related concepts are described below.

The Fresnel lens is a thin lens. By dividing the continuous original curved surface of an ordinary lens into several segments, after the thickness of each curved segment is reduced, all the curved surface segments are put on the same plane or the same substantially smooth curved surface to form the Fresnel lens. This discontinuous refraction surface evolved from the original curved surface can be called a Fresnel refraction surface, which is generally step-shaped or tooth-shaped. In theory, the Fresnel refraction surface has an optical performance approximate to that of the corresponding original curved surface, but its thickness is greatly reduced. The Fresnel refraction surface produced by one original curved surface can be called a Fresnel unit.

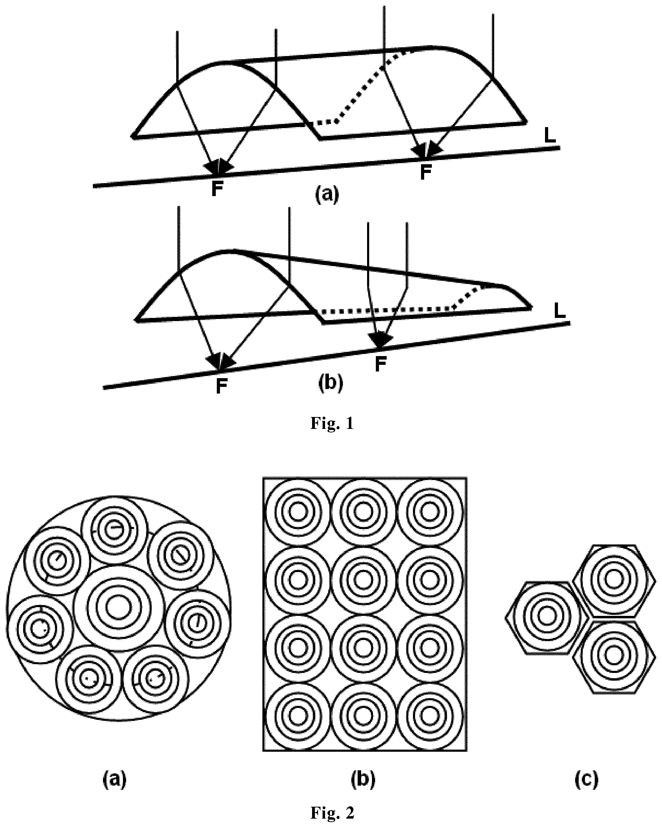

Conventional original curved surfaces for generating Fresnel refraction surfaces are generally curved surfaces that are symmetrical about the optical axis, such as spherical surfaces and rotating curved surfaces (such as rotating paraboloids). The focuses of the conventional original curved surfaces are at one point and therefore they can be called "concurrent planes". In the present invention, the original curved surfaces may be any form of coaxial surfaces, which may be specifically arranged as needed by the application. The term "coaxial surfaces" refers to curved surfaces whose focuses are on the same line (not necessarily at the same point), which may be referred to as a "coaxial line". The conventional concurrent planes can be regarded as a special case when the coaxial line of the coaxial surfaces is degraded to a point. Due to use of original surfaces which are coaxial but not concurrent, a sensing element configured at the focusing location may be expanded from a smaller area (corresponding to the focal point) to a long strip (corresponding to a coaxial line consisting of focuses), thereby enhancing the capability of signal collection and helping solve the problem of local overheating, without significantly increasing the cost. Typical coaxial surfaces include rotating curved surfaces (including rotating curved surfaces of the second order or a higher order), column surfaces, tapered surfaces, and the like. The column surfaces can be called constant-section coaxial surfaces, and their sections obtained through cutting off these curved surfaces at any point along a direction perpendicular to the coaxial line are consistent in shape and size. A cylindrical surface is a special case of column surfaces. The cross sections of tapered surfaces along the coaxial line are similar in shape but different in size, and a conical surface is a special case of tapered surfaces. Fig. 1 shows the above-mentioned two types of coaxial surfaces, where Fig. 1 (a) shows a constant-section coaxial surface, and Fig. 1 (b) shows a tapered coaxial surface with the focus F on the respective coaxial line L.

A macroscopic refraction plane consisting of one or more Fresnel units may be referred to as a tooth surface, and a substantially smooth or flat surface opposite thereto may be referred to as a back surface. A tooth surface containing only one Fresnel unit can be referred to as a "simple Fresnel refraction surface" and a tooth surface containing two or more Fresnel units is referred to as a "composite Fresnel refraction surface". In general, the basic parameters (for example, area, focal length, the shape of the corresponding original curved surface, the number of concentric rings used to split the original curved surface, etc.) of the Fresnel units on the composite Fresnel refraction surface can be flexibly configured and may be completely identical, partially identical or completely different. In one embodiment, all Fresnel units on the composite Fresnel refraction surface have their own optical centers, but their focuses fall at the same point, or on a straight line, or in a limited area. This can be achieved by spatial arrangement of each Fresnel unit constituting the composite Fresnel refraction surface. Fig. 2 shows arrangements of Fresnel units of several typical Fresnel refraction surfaces, where Fig. 2(a) shows a circularly symmetrical arrangement, Fig. 2(b) shows an arrangement in the form of rows and columns, and Fig. 2(c) is a honeycomb arrangement. It may be contemplated that these Fresnel units are arranged on a macroscopic curved surface, such as a plane, a quadratic surface (including a spherical surface, an ellipsoid, a cylindrical surface, a parabolic cylinder surface, a hyperbolic cylinder surface), a high-order polynomial surface (a general implementation way of an aspheric surface), and a fold surface and a stair-shaped surface formed by jointing multiple planes, etc.

In general, the tooth surface and the back face can be flexibly combined to form different types of elements. For example, a Fresnel lens with a tooth surface and a back surface may be referred to as a "single-sided Fresnel lens". Further, if the tooth surface is a "simple Fresnel refraction surface", then the lens is a "single-sided simple Fresnel lens"; if the tooth surface is a "composite Fresnel refraction surface", then the lens is a "single-sided composite Fresnel lens". A Fresnel lens with both sides being tooth surfaces can be called a "double-sided Fresnel lens", and according to the type of the tooth surfaces, it could also be further divided into a "double-sided simple Fresnel lens" and a "double-sided composite Fresnel lens". If one tooth surface of a double-sided Fresnel lens is a simple Fresnel refraction surface and the other tooth surface is a composite Fresnel refraction surface, it can be referred to as a "double-sided hybrid Fresnel lens". In addition, as a variant, for a double-sided Fresnel lens, if one of the tooth surfaces is a "simple Fresnel refraction surface", this tooth surface may be replaced by a conventional convex lens surface or concave lens surface.

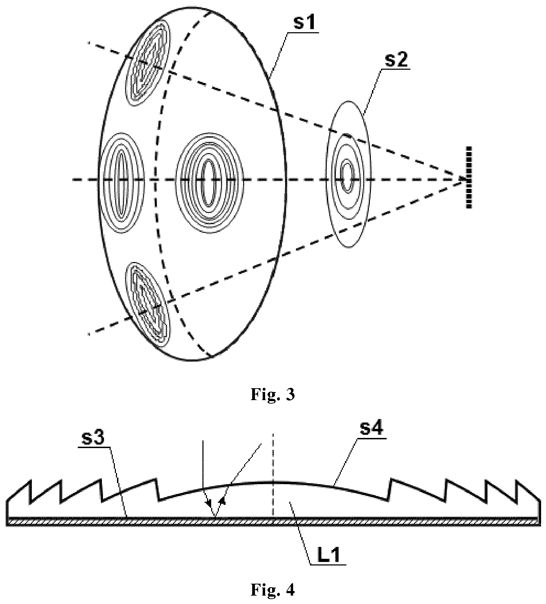

Setting two or more tooth surfaces on the same optical path allows the convergence system to have better convergence capability. Fig. 3 shows a convergence system with two tooth surfaces where the composite Fresnel refraction surface s1 and the simple Fresnel refraction surface s2 may be provided by one double-sided Fresnel lens or provided by two single-sided Fresnel lenses separately.

The reflection surface used in the convergence system of the present invention may be a planar reflection surface or a curved reflection surface, such as a concave or convex reflection surface, and may also be a tooth-shaped reflection surface. The reflection surface may be provided by an element having only one single reflection function, such as a flat plate having a reflection coating, and light is reflected directly on the surface of the element. The reflection surface may also be provided by a reflection lens. The so-called reflection lens refers to a lens having a reflection coating on one side, and light is refracted into the lens from a refraction surface and then reflected by a reflection surface, and refracted again out of the element through a transmission surface.

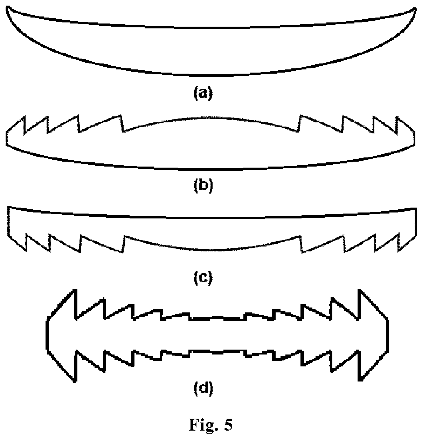

Different types of reflection surfaces can be combined with different types of transmission surfaces to form different types of reflection lenses. For the sake of simplicity, when naming a reflection lens, the type of the reflection surface is placed in front of the type of a refraction surface. For example, the combination of a planar reflection surface and a planar transmission surface is a common planar reflector, and the combination of a planar reflection surface and a concave or convex transmission surface is a "planar-concave" or "planar-convex" reflection lens; in the same way, there may be reflection lenses of "concave-planar", "convex-planar", "concave-concave", "convex-convex", "concave-convex" and "convex-concave" types, etc. Specifically, a Fresnel reflection lens can be obtained by replacing one or both of curved surfaces in a reflection lens with a corresponding tooth surface(s). For "planar-convex" Fresnel-type reflection lens, reference can be made to Fig. 4, where the component L1 has a planar reflection surface s3 and a simple Fresnel refraction surface s4. Due to the reflection, an incident light path passes through a physical refraction interface s4 twice, and the physical interface is actually equivalent to two tooth surfaces, so the component L1 may also be referred to as a reflection-type double-sided Fresnel lens. The component L1 may be formed by plating a reflection film on the back surface of a single-sided Fresnel lens or by attaching a patch having a reflection capability to the back surface. Other types of reflection lenses may also be formed by turning any one of surfaces of the original lens into a reflection surface. For several typical original lean, reference can be made to Fig. 5, where Fig. 5 (a) shows a "concave-convex" lens, Fig. 5 (b) shows a "convex-convex" lens with one convex surface being a Fresnel refraction surface, Fig. 5 (c) is a "concave-convex" lens with the convex surface being a Fresnel refraction surface, and Fig. 5 (d) is a "concave-concave" lens with both sides being Fresnel refraction surfaces.

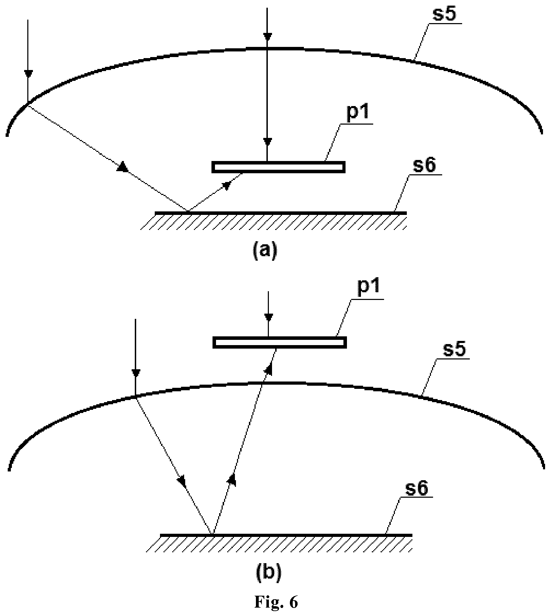

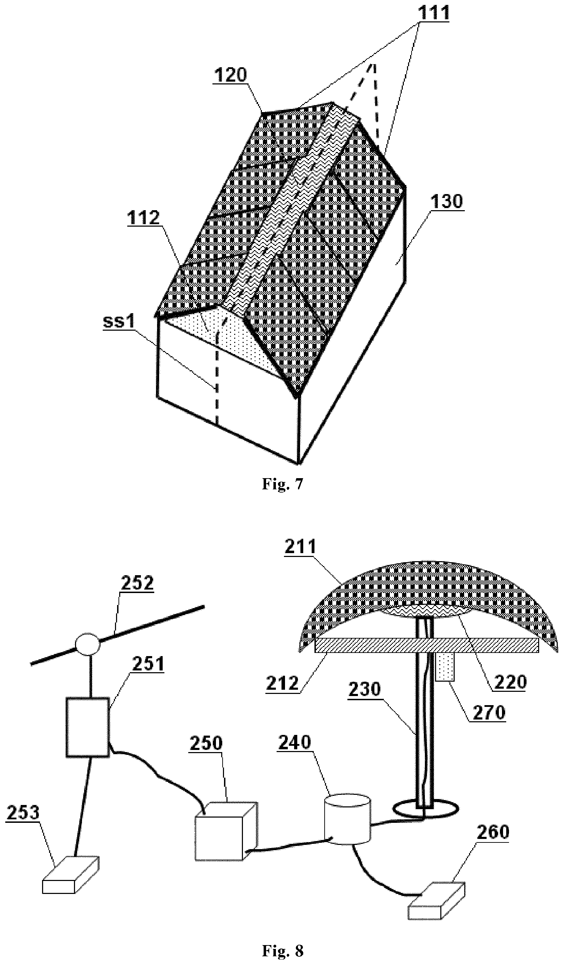

The basic structure of the concentrated solar energy system according to the present invention, referring to Fig. 6, comprises a convergence system and a double-sided photovoltaic panel p1. The convergence system comprises a tooth surface s5 and a reflection surface s6, wherein the tooth surface contains at least one Fresnel unit, and the reflection surface is arranged below the tooth surface along a sunlight incident direction. The double-sided photovoltaic panel is arranged above the reflection surface along the sunlight incident direction. As shown in Fig. 6 (a), the double-sided photovoltaic panel may be located between the tooth surface and the reflection surface; or as shown in Fig. 6 (b), the double-sided photovoltaic panel may be located above the tooth surface. In some embodiments, the double-sided photovoltaic panel may also be in close contact with the tooth surface or embedded in the macroscopic curved surface on which the tooth surface is located, as shown in Fig. 7. The double-sided photovoltaic panel may be disposed on the path of focused light, preferably, basically in a focusing location of the convergence system, and the focusing location is determined synthetically by the tooth surface and the reflection surface. In general, the focusing location is a spot-like or strip-like small area, and the double-sided photovoltaic panel is located near the area to receive converged sunlight with increased energy density. In various embodiments, the tooth surface and the reflection surface may be provided by the various types of components described above. For example, different components may be used to provide the tooth surface and the reflection surface, respectively, and the component shown in Fig. 4 may also be used to provide both the tooth surface and the reflection surface. In addition, the convergence system can also be further enhanced in the convergence capability by means of increasing tooth surfaces. The double-sided photovoltaic panel used in the present invention is capable of absorbing incident sunlight from both the front and back surfaces. A simple approach is to stack two single-sided photovoltaic panels back to back to obtain a double-sided photovoltaic panel. Of course, it is also possible to directly make a photovoltaic device with double-sided light absorption capability. A proper support component (not shown) may be used to support the convergence system and the double-sided photovoltaic panel to maintain the relative position relationship therebetween. Depending on different particular application scenarios, the support component may have a variety of proper forms and may be designed as desired.

In some preferred embodiments, the convergence system and the double-sided photovoltaic panel may have the same symmetrical dividing plane. The so-called symmetric dividing plane is a plane that divides a geometrical shape into two parts, and the two divided parts are symmetrical with respect to the plane. A circumferentially symmetric object has an infinite number of symmetric splitting planes, and all the planes passing through their central normal are symmetrical dividing planes, and a rectangular plane only have two symmetrical dividing planes. The advantage that the elements have the same symmetrical dividing plane is that the spatial size can be fully utilized to achieve a compact arrangement.

Several use forms of the concentrated solar energy system according to the present invention will be described as specific examples below in connection with specific application scenarios.

### Embodiment 1

An embodiment of a concentrated solar energy system according to the present invention, referring to Fig. 7, comprises a first Fresnel lens 111, a reflection element 112, a double-sided photovoltaic panel 120, and a support component 130.

The first Fresnel lens 111 may be provided with one tooth surface (using a single-sided Fresnel lens) or two tooth surfaces (using a double-sided Fresnel lens) and the macroscopic curved surface of its tooth surface is shaped as a fold surface. In other embodiments, the shape of the macroscopic curved surface of the tooth surface of the first Fresnel lens may also be a coaxial surface of other shapes, such as an arc surface. In the present embodiment, the first Fresnel lens is used as a roof for a building and can be made by pressing a rigid transparent material such as hard plastic, resin, glass, or the like. As the roof area is usually large, the first Fresnel lens can be divided into several small parts to be manufactured, and then spliced together. For example, a lot of simple Fresnel lenses may be manufactured, and then assembled into the entire roof. Of course, each small part may also comprise multiple Fresnel units based on the manufacturing method. These small parts for assembling a light convergence roof can be called "convergence tiles".

The reflection element 112 is laid flat beneath the roof, and due to the large area, a simple element having a reflection plane, such as a plate or film coated with a reflection layer, may be used.

The first Fresnel lens 111 and the reflection element 112 form a convergence system, a strip-like focusing location of which is designed at the ridge of the roof, i.e. on the macroscopic curved surface of the first Fresnel lens. This design will bring great convenience for installation of a double-sided photovoltaic panel, and the entire solar energy system forms a relatively closed space. The sunlight that is converged by the first Fresnel lens will be reflected several times among the tooth surface, the reflection surface and the photovoltaic panel till it is absorbed or reflected back to the sky. Since very little sunlight is reflected back to the sky, the solar roof of the present embodiment can efficiently absorb sunlight and therefore is suitable for being used as the roof for houses in a cold area, and because the reflection surface can effectively reflect heat energy, the solar roof is also suitable for being used as the roof for houses in a tropical area. It should be noted, however, that the material used for making the reflection surface is preferably transparent to radio signals so as not to affect the indoor radio communication quality.

In the application scenario of the present embodiment, the support component 130 comprises a wall of a house and a bracket (not shown) for supporting and mounting the first Fresnel lens and the photovoltaic panel, etc.

In the present embodiment, the convergence system (comprising the first Fresnel lens and the reflection element) has the same symmetrical dividing plane ssl (as denoted by the dotted line in the figure) as the double-sided photovoltaic panel, which makes the space well utilized.

As a preferred embodiment, in order to further improve the utilization of solar energy, a second Fresnel lens (not shown) may be arranged above the double-sided photovoltaic panel in the sunlight incident direction to converge sunlight directly radiated on the front surface of the photovoltaic panel. The second Fresnel lens not only can improve the utilization of solar energy, but also can achieve the function of dust and snow prevention.

The solar energy system in the present embodiment can be directly used as a roof for a new building or can be modified from a roof of an existing building.

### Embodiment 2

Another embodiment of a concentrated solar energy system according to the present invention, referring to Fig. 8, comprises a first Fresnel lens 211, a reflection element 212, a double-sided photovoltaic panel 220, and a support component 230.

The macroscopic curved surface of the tooth surface of the first Fresnel lens 211 is of a circumferentially symmetric shape and can be used as the top surface of a tent or the top surface of an umbrella. The present embodiment can be regarded as an application scenario in which the solar energy system is used as an outdoor sunshade umbrella. The first Fresnel lens can be made by pressing a flexible transparent material, such as soft plastic, a flexible crystal plate or the like. The entire umbrella surface can be divided into several small parts to be manufactured, and then spliced together.

The reflection element 212 is arranged below the umbrella surface. Since in this type of application it is desirable that the convergence system has a short focal length, a reflection lens with enhanced convergence capability, such as the "convex-convex" Fresnel reflection lens as shown in Fig. 5 (b), may be used as the reflection element, and in order to facilitate processing, a reflection film can be plated on the smooth convex surface.

The first Fresnel lens 211 and the reflection element 212 form a convergence system and its spot-like focusing location is designed between the umbrella surface and the reflection element such that the double-sided photovoltaic panel can be physically protected by the umbrella surface. The sunshade umbrella with a structure as described in the present embodiment is excellent in shading effect, and it is possible for the photovoltaic panel with a small area to obtain most of light energy that is irradiated to the umbrella surface, thus achieving a very good solar energy collecting ability. Moreover, the convergence system has the same symmetrical center line as that of the double-sided photovoltaic panel, i.e., the position where the support component 230 is located, so that the use of the space is maximized and the convergence system and the photovoltaic panel can be easily mounted on the support component.

This type of umbrella-shaped solar energy system can be used as a home solar power station, which has good mobility, for example, can be placed on a roof to replace the solar roof described in Embodiment 1. This umbrella-shaped solar system can also be installed in a parking lot, a highway rest station or the like as a solar power generation system. Specifically, it is possible to install this kind of umbrella-shaped solar energy system by using various existing wire poles and light poles, thereby providing a large amount of clean energy.

In order to better store and utilize the electrical energy obtained from the solar energy conversion, the present embodiment also comprises additional elements listed below, and in other embodiments, it may be possible to selectively include only one or more of them according to the needs of the application:
an energy storage 240, electrically connected to the double-sided photovoltaic panel 220 and used for storing electric energy, wherein The energy storage may be selected from a supercapacitor, a rechargeable battery and an air compressor;
an AC inverter 250, electrically connected to the energy storage (in other embodiments, it may also be electrically connected directly to the double-sided photovoltaic panel) and used for outputting and connecting its power to a networking switch cabinet 251, wherein the networking switch cabinet is connected to an external AC power grid 252 so that the electrical energy generated by the solar energy system can be incorporated into the external power grid, and the AC inverter can also be externally connected to the AC terminal board 253 to provide the AC output directly to users;
a DC voltage output device 260, electrically connected to the energy storage (in other embodiments, it may also be directly electrically connected to the double-sided photovoltaic panel) and used for outputting a DC voltage for use by users, wherein the DC voltage output from the output device may include, for example, 12V, 9V, 5V, 3V, 1.5V and so on; and
a status indicator 270 for detecting and displaying the operating parameters of the system, wherein these operating parameters may be voltage, current, power, temperature, etc., so that users can know the operating conditions of the solar energy system, and these parameters can be obtained by arranging detectors (such as a temperature probe) corresponding to the types of the required parameters.

### Embodiment 3

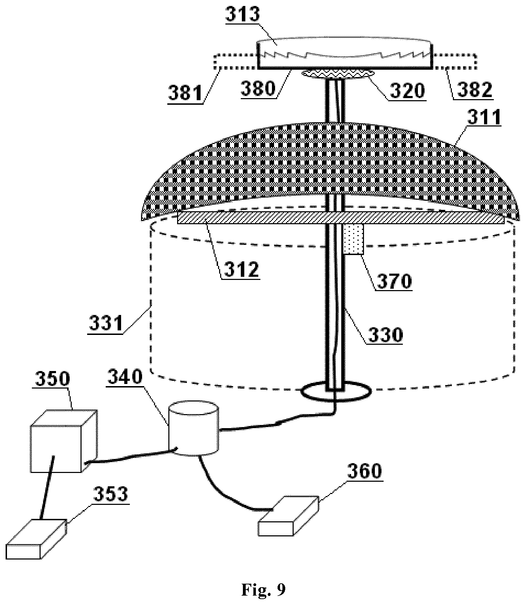

Another embodiment of a concentrated solar energy system according to the present invention, referring to Fig. 9, comprises a first Fresnel lens 311, a reflection element 312, a double-sided photovoltaic panel 320, and a support component 330.

The first Fresnel lens 311 is a single-sided or double-sided composite Fresnel lens with a macroscopic curved surface being of a circumferentially symmetric shape. In the present embodiment, the first Fresnel lens is used as the top cover of a tent, and may be made by pressing a flexible transparent material or made by splicing small parts made of a flexible transparent material.

The reflection element 312 is arranged below the top cover. Since it is desirable in the present embodiment that the convergence system has a longer focal length, the reflection element may adopt a reflection lens with one surface being a concave surface, for example, a "concave-convex" Fresnel reflection lens as shown in Fig. 5 (c), and in order to facilitate processing, a reflection film can be plated on a smooth concave surface.

The first Fresnel lens 311 and the reflection element 312 form a convergence system and its spot-like focusing location is designed above the top cover, and this structure can improve the utilization efficiency of sunlight and can facilitate the installation and maintenance of the double-sided photovoltaic panel.

In order to make full use of solar energy, a second Fresnel lens 313 and a water heater 380 made of a transparent material are also included in the present embodiment. The second Fresnel lens 313 is arranged above the double-sided photovoltaic panel 320 and used for converging sunlight entering from the front surface. The double-sided photovoltaic panel 320, as a heat source, is wrapped by the water heater 380 in a heat conduction manner, for example, heat exchange is implemented through close contact with the water heater by means of a thermally conductive material. Cold water enters the water heater from a water inlet 381, exchanges heat with the double-sided photovoltaic panel, and then flows out from a water outlet 382. The second Fresnel lens tooth face is arranged downward at the top of the water heater so that water in the water heater becomes a liquid Fresnel lens.

In the present embodiment, the center lines of the convergence system, the photovoltaic panel, the second Fresnel lens, the water heater, and the like coincide with the support component 330, and also have high space use efficiency. Hooks or holes (not shown) are arranged around the top cover to install an awning 331 on the hooks or the holes, thereby turning the solar energy system of the present embodiment into a solar tent with electric power and hot water supply.

Since the present embodiment mainly intended for use in the wild and does not need to connect with an external AC power grid, additional elements only include an energy storage 340, an AC inverter 350, a DC voltage output device 360, and a status indicator 370, and the AC inverter is externally connected with an AC terminal board 353. Description of the additional elements is same as in Embodiment 2.

### Embodiment 4

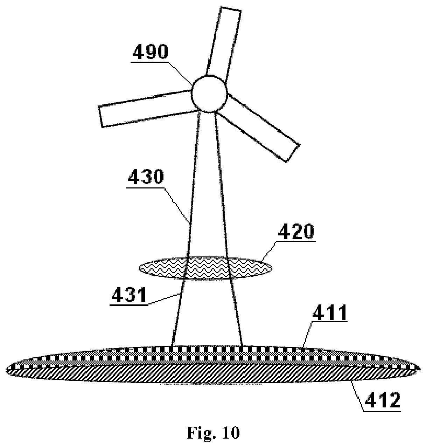

Another embodiment of a concentrated solar energy system according to the present invention, referring to Fig. 10, comprises a first Fresnel lens 411, a reflection element 412, a double-sided photovoltaic panel 420, and a support component 430.

The present embodiment is an application example in which the solar energy system of the present invention is combined with a wind-driven generator. The first Fresnel lens 411 is a single-sided or double-sided composite Fresnel lens, and the reflection element 412 is a reflection lens or a Fresnel reflection lens. The element shown in Fig. 4 may also be used to provide both the tooth surface and the reflection surface, and the tooth surface thereof may be replaced with a composite Fresnel refraction surface.

The first Fresnel lens 411 and the reflection element 412 are arranged at the bottom of the wind-driven generator 490, for example on the ground. The double-sided photovoltaic panel 420 is mounted at the lower middle part of the support component 430, which is also a support component for the wind-driven generator 490. For a newly built solar and wind-driven power generation systems, a hollowed-out steel support may be used as the support component, in order to avoid blocking the sunlight from irradiating the convergence system. If a solar energy system according to the present invention is mounted on a support of an existing wind-driven generator, a section 431, between the first Fresnel lens 411 and the double-sided photovoltaic panel 420, of the support component may be plated with a reflection film.

In the present embodiment, the wind-driven power generation system is integrated with the solar power generation system, and the two different natural energy sources (i.e., wind and solar energy) are used in combination by virtue of the same space, the same support, the same set of power transmission system, the same set of inverter, control and storage devices, thus reducing system cost and improving the adaptability of the integrated system to the climate.

The principles and embodiments of the present invention are illustrated above by using specific examples, and it is to be understood that the foregoing embodiments are merely used for facilitate understanding the present invention and are not to be construed as limiting the invention. For those skilled in the art, changes may be made to the specific embodiments described above in accordance with the conception of the present invention. For example, if the reflection surface in the above embodiments is arranged on a roof, the ground/a road, water, or a window, the corresponding solar energy system becomes a solar roof, a ground/road solar energy system, a solar artificial island, or a solar window.

## Claims

1. A concentrated solar energy system, comprising:
a convergence system, comprising at least one tooth surface (s5) and a reflection surface (s6), each tooth surface containing at least one Fresnel unit, and the reflection surface being arranged below the tooth surface along a sunlight incident direction;
a double-sided photovoltaic panel (p1), arranged above the reflection surface along the sunlight incident direction and basically located at a focusing location of the convergence system, the double-sided photovoltaic panel be used for absorbing incident sunlight from two directions, i.e., from a front surface and a back surface; and
a support component for supporting the convergence system and the double-sided photovoltaic panel and maintaining the relative position relationship therebetween.

2. The solar energy system of claim 1, wherein the convergence system and the double-sided photovoltaic panels (120, 220, 320, 420) have the same symmetric dividing plane.

3. The solar energy system of claim 1, wherein the macroscopic curved surface of the tooth surface is in the shape of a circumferentially symmetric surface or a coaxial surface.

4. The solar energy system of claim 1, wherein the focusing location is located between the tooth surface and the reflection surface or is located above the tooth surface along the sunlight incident direction or is on the macroscopic curved surface of the tooth surface.

5. The solar energy system of any of claims 1-4, wherein the convergence system comprises a first Fresnel lens (111, 211, 311, 411) and a reflection element (112, 212, 312, 412), wherein
the type of first Fresnel lens is selected from a single-sided simple Fresnel lens, a single-sided composite Fresnel lens, a double-sided simple Fresnel lens, a double-sided composite Fresnel lens and a double-sided hybrid Fresnel lens;
the type of the reflection element is selected from a reflection element only having a single reflection plane or reflection curved surface, a planar reflector, a reflection lens formed by combining a planar reflection surface and a concave or convex transmission surface, and a Fresnel reflection lens.

6. The solar energy system of any of claims 1-4, further comprising a second Fresnel lens (313) arranged above the double-sided photovoltaic panel (320) along the sunlight incident direction.

7. The solar energy system of any of claims 1-4, further comprising one or more of the following elements:
an energy storage, electrically connected to the double-sided photovoltaic panel and used for storing electric energy, the energy storage being selected from a supercapacitor, a rechargeable battery and an air compressor;
an AC inverter, electrically connected to the energy storage and used for outputting and connecting its power to a networking switch cabinet;
a DC voltage output device, electrically connected to the double-sided photovoltaic panel and used for outputting an AC voltage; and
a status indicator for detecting and displaying the operating parameters of the system, these operating parameters being selected from voltage, current, power and temperature.

8. The solar energy system of claim 5, wherein the first Fresnel lens is made by pressing a rigid or flexible transparent material or by splicing small parts made of a rigid or flexible transparent material.

9. The solar energy system of claim 5, wherein the first Fresnel lens is used for functioning as a roof for a building, or the umbrella surface of an umbrella, or the top cover of a tent.

10. The solar energy system of any of claims 1-4, wherein the reflection surface is used for being arranged on a roof, or the ground, or water, or a window.

11. The solar energy system of any of claims 1-4, further comprising a water heater (380) made of a transparent material, wherein the double-sided photovoltaic panel, as a heat source, is wrapped by the water heater in a heat conduction manner.

12. The solar energy system of any of claims 1-4, wherein the solar energy system and a wind-driven generator (490) share the support component (430) and power transmission, inverter, control and storage devices.
